# EUROPEAN PATENT APPLICATION

(11) **EP 2 270 598 A1**
(43) Date of publication of application: **05.01.2011**
(21) Application number: 09734419.6
(22) Date of filing: 23.03.2009
(51) Int. Cl.: G03F 7/20, H01L 21/027

(54) **LASER EXPOSURE METHOD, PHOTORESIST LAYER WORKING METHOD, AND PATTERN MOLDING MANUFACTURING METHOD**

(30) Priority: 22.04.2008 JP 2008111737; 16.02.2009 JP 2009032581
(71) Applicant: FUJIFILM Corporation, Tokyo 106-8620 (JP)
(72) Inventor: USAMI, Yoshihisa, Ashigarakami-gun Kanagawa 258-8538 (JP)
(74) Representative: Klunker . Schmitt-Nilson . Hirsch
(86) International application number: PCT/JP2009/001257
(87) International publication number: WO 2009/130846

(57) **Abstract**

A laser exposure method for performing exposure is provided in which a supporting stage (2) supporting a plurality of objects (workpieces 5) and a laser beam illumination device (3) illuminating the objects while a focus servo control based on reflected light is being effected are moved relative to each other. The method includes a control start step of starting the focus servo control when the laser beam has reached a focus start position (FS) on an object; a control stop step of stopping the focus servo control when the laser beam has reached a focus stop position (FE) on the object; and a retaining step of retaining a position of an optical component (objective lens 35) at a predetermined position for a period until the laser beam starting from the focus stop position (FE) on the object reaches a focus start position (FS) on a subsequent object.

## Description

### TECHNICAL FIELD

The present invention relates to a laser exposure method for illuminating a plurality of separate objects with a laser beam while exercising a focus servo control over each object, a photoresist layer processing method, and a method for manufacturing a patterned casting.

### BACKGROUND ART

In general, it is a known technique to form pits and projections on a surface of a workpiece (object) on which a photoresist layer is applied, by illuminating the workpiece with a laser beam and then removing illuminated portions through a development process. If this technique were implemented in processing on a workpiece that is being caused to rotate (on its axis), it would take more time to perform processing on a portion of the rotating workpiece closer to its center of rotation because the rotation speeds of the rotating workpiece are slower toward the center of rotation, and the portion of the workpiece closer to the center of rotation would be difficult to process precisely in view of a correlation between the laser output and the rotation speed.

To address these problems, the inventor named in the present application has embraced an idea of a method for processing a plurality of workpieces in a single step by causing the workpieces to revolve around a center of rotation of a workpiece supporting stage on which the workpieces are arranged in a circumferential direction of the supporting stage in positions such that the workpieces do not overlap the center of rotation of the supporting stage. With this method, however, a focus servo control exercised during the processing of each workpiece would possibly not proceed appropriately due to a difference between a reflectance of a surface of each workpiece and a reflectance of an area (of the supporting stage) between the workpieces.

As conventional techniques relating to the aforementioned focus servo control, a technique in which information is recorded in or retrieved from an information recording medium for testing (hereinafter referred to as "test piece") is known, though this is not a technique for forming pits and projections on a surface of a workpiece (*see* JP 3-134832 A). To be more specific, in this technique, a plurality of test pieces are arranged in a circumferential direction of a rotary table in positions such that the workpieces do not overlap the center of rotation of the rotary table, and a focus servo control based on reflected light is exercised when a head is performing a recording or retrieving operation on each test piece, while an objective lens included in the head is caused to reciprocate upward and downward within a predetermined focus control permissible range without utilizing the reflected light when the head is passing over between two test pieces. Therefore, after the head has passed over between the two test pieces and reached a second test piece thereof, the objective lens has already been in the focus control permissible range, and thus the focus servo control can be exercised over the second test piece appropriately.

However, in this conventional technique, since the objective lens is caused to reciprocate upward and downward when it is between the two test pieces, the objective lens would possibly be shifted greatly from a normal position at a time when it reaches the second test piece, as the case may be; in this case, disadvantageously, extra time is required to elapse before the focus servo control becomes stable in this case.

Accordingly, it is desired to provide a laser exposure method, a photoresist layer processing method, and a manufacturing method for a patterned casting, in which the focus servo control can be stabilized more quickly.

### DISCLOSURE OF INVENTION

In one aspect of the present invention, a laser exposure method for exposing a plurality of objects with a laser beam is provided, in which a supporting stage supporting the plurality of objects spaced out thereon and a laser beam illumination device illuminating the objects with the laser beam while a focus servo control is being effected, under which an optical component thereof is moved based on reflected light, are moved relative to each other in a direction of arrangement of the plurality of objects. This method comprises: a control start step of starting the focus servo control, on condition that the laser beam emitted from the laser beam illumination device has reached a focus start position on an object; a control stop step of stopping the focus servo control, on condition that the laser beam emitted from the laser beam illumination device has reached a focus stop position on the object; and a retaining step of retaining a position of the optical component at a predetermined position for a period starting from a time when the laser beam emitted from the laser beam illumination device has reached the focus stop position on the object until the laser beam emitted from the laser beam illumination device reaches a focus start position on a subsequent object.

In this mode of the present invention, when a laser beam moving relative to an object reaches a focus start position on the object, the focus servo control is started. To be more specific, the optical component is moved based on reflected light reflected from the object, and the laser beam emitted from the laser beam illumination device is focused on a specific position in the object. When a laser beam reaches a focus stop position on the object, the focus servo control is stopped, and the position of the optical component is retained at the predetermined position. Thereafter, when a laser beam reaches a focus start position on a subsequent object, the focus servo control is started again, and the optical component is started to be moved from the predetermined position. Accordingly, if the surface positions of the plurality of objects placed at the supporting stage are so set as to come in substantially the same position relative to the predetermined position, the position of the optical component relative to a subsequent object will be retained in a position close to the normal position (equivalent to the in-focus position, as will be discussed later) when the laser beam is moved from a currently focused object to the subsequent object, so that the focus servo control can be stabilized more quickly.

In the above configuration, optionally, the focus start position and the focus stop position may be set at positions in which the laser beam in its entirety is applied to the object.

With this feature, since the whole laser beam is applied to the object when it is in the focus start position and in the focus stop position, the potential risk, such as failure to properly exercise the focus servo control, which would be caused in the event that the laser beam is applied partially off the object, can be prevented.

In the above configuration, emission of the laser beam from the laser beam illumination device during the retaining step may be configured to continue uninterruptedly or intermittently.

With this feature, compared with the method in which emission of the laser beam during the retaining step is stopped, the laser beam may be emitted more stably when the focus servo control is started for the subsequent object.

In addition, emission of the laser beam from the laser beam illumination device during the control start step, the control stop step and the retaining step may be configured to continue intermittently.

With this configuration, the control on the laser beam illumination device may be achieved in a simplified mode such that emission of the laser beam is always caused to continue intermittently; therefore, the control can be effected with improved accuracy.

The predetermined position may be a position of the optical component located when the focus servo control is stopped.

With this feature, the optical component is retained at the position which is the position of the optical component located when the focus servo control is stopped, and thus any useless motion of the optical component can be avoided, so that the wearing of a drive system therefor can be minimized.

Alternatively, the predetermined position may be in a position corresponding to a surface of the subsequent object which is to be illuminated next.

With this feature, even if the surface positions of the plurality of objects can not be so set as to come in substantially the same position, the focus servo control can be exercised properly over the subsequent object because the optical component is moved to and retained at the position corresponding to the surface of the subsequent object which is to be illuminated next.

Alternatively, the predetermined position may be in a position corresponding to an interval between peaks of an S-curve of a focus error signal.

Hereupon, the "focus error signal" refers to a known type of signal curved in the form of a letter S, which is obtained based on reflected light when the optical component is moved simply in one direction along the direction of its optical axis without the focus servo control being exercised. It is appreciated that the focus servo control will readily be effected when it is between peaks of the S-curve of the focus error signal.

With this feature, the focus servo control over the subsequent object can be initiated properly because the optical component is retained at the position which is in a position corresponding to the interval between the peaks of the S-curve of the focus error signal.

The supporting stage may be rotated to cause the plurality of objects to revolve around an axis of rotation of the supporting stage.

With this configuration, simple in structure, the plurality of objects can be moved relative to the laser beam illumination device.

The laser beam may be applied to a portion of the object which is defined to range between a position not less than 1 µm inside from an edge closer to the axis of rotation of the supporting stage and a position not less than 1 µm inside from an edge farthest from the axis of rotation of the supporting stage.

With this feature, the potential risk, such as failure to properly exercise the focus servo control as a result of application of the laser beam partially off the object, which would be caused in the event that the object has a chipped portion at its edge, can be prevented.

In a photoresist layer processing method, as another aspect of the present invention, a supporting stage supporting a plurality of objects each having a photoresist layer, the plurality of objects being spaced out thereon, and a laser beam illumination device illuminating photoresist layers of the objects with a laser beam while a focus servo control is being effected, under which an optical component thereof is moved based on reflected light, are moved relative to each other in a direction of arrangement of the plurality of objects, to expose the photoresist layers of the plurality of objects with the laser beam. The photoresist layer processing method comprising: a control start step of starting the focus servo control, on condition that the laser beam emitted from the laser beam illumination device has reached a focus start position on an object; a control stop step of stopping the focus servo control, on condition that the laser beam emitted from the laser beam illumination device has reached a focus stop position on the object; and a retaining step of retaining a position of the optical component at a predetermined position for a period starting from a time when the laser beam emitted from the laser beam illumination device has reached the focus stop position on the object until the laser beam emitted from the laser beam illumination device reaches a focus start position on a subsequent object.

In this mode, the optical component is retained at a predetermined position for a period starting from a time when the laser beam has reached the focus stop position on the object until the laser beam reaches the focus start position on the subsequent object, and thus the position of the optical component can be retained at a position close to the normal position for the subsequent object as well, so that the focus servo control can be stabilized more quickly and the processing can be performed properly.

In this photoresist layer processing method, the following steps may be provided: a processing start step of increasing a laser beam output to a level greater than that of the laser beam outputted at a time of starting the focus servo control, on condition that the laser beam has reached a processing start position on the object, the processing start position being set at a position rearward of the focus start position with respect to a moving direction of the objects; and a processing stop step of lowering the laser beam output to a level of the laser beam outputted at the time of starting the focus servo control, on condition that the laser beam has reached a processing stop position on the object, the processing stop position being set at a position forward of the focus stop position with respect to the moving direction of the objects.

With this feature, first, when the laser beam reaches the focus start position on the object, the focus servo control is started using a laser beam emitted from the laser beam illumination device at a predetermined output value. Thereafter, when the laser beam reaches the processing start position, the output of the laser beam emitted from the laser beam illumination device is increased, and the photoresist layer is processed using this high-power laser beam. Thereafter, when the laser beam reaches the processing stop position, the output of the laser beam emitted from the laser beam illumination device is lowered, and the processing of the photoresist layer ends. Thereafter, when the laser beam reaches the focus stop position, the focus servo control is stopped, and the position of the optical component is retained at the predetermined position. Accordingly, the processing of the photoresist layer is performed with the laser beam while the focus servo control is being effected properly over each object, so that the photoresist layer of each object can be processed with adequate precision.

In the processing start step of the photoresist layer processing method as described above, a laser beam output may be increased to a level greater than that of the laser beam outputted at the time of starting the focus servo control, on condition, in lieu of the aforementioned condition, that a distance at which the optical component is short of an in-focus position thereof, as determined during the focus servo control, has fallen within ±300 µm.

In this specification, the "in-focus position" is not the position on which a laser beam is focused, but the position of the optical component through which the object is illuminated properly with the laser beam (properly focused).

With this configuration, when the distance to the in-focus position of the optical component has fallen within ±300 µm, the optical component is substantially in the in-focus position, and thus the photoresist layer can be formed into a desirably processed shape from a point of time when the laser beam output is increased to start processing. Consequently, low-yield processing can be avoided, and the power consumption increased according to the increase in the laser output can be reduced.

In the focus servo control of the photoresist layer processing method as described above, a processing prohibition control may be executed when a distance at which the optical component is short of an in-focus position thereof, as determined during the focus servo control, has fallen out of a predetermined range, wherein the processing prohibition control includes causing a laser beam output to be changed to or maintained at a level of the laser beam outputted at a time of starting the focus servo control.

With this configuration, when the distance to the in-focus position of the optical component has fallen out of the predetermined range and the focus servo control thereby cannot be executed, the laser beam output is changed to or maintained at the level of the laser beam outputted at the time of starting the focus servo control to thereby prohibit the processing; consequently, useless increase in the laser output and the low-yield processing can be restricted.

In the photoresist layer processing method as described above, at least one of the supporting stage and the laser beam illumination device may be moved relative to each other when the processing prohibition control is executed, to locate the laser beam back to the same position as a focus start position that is being set at a time of execution of the processing prohibition control.

With this configuration, when the focus servo control cannot be executed, the focus servo control is resumed from the same focus start position to perform processing, and thus production of defectives can be reduced.

In the photoresist layer processing method as described above, defect information may be recorded in a memory when a distance at which the optical component is short of an in-focus position thereof, as determined during the focus servo control, has fallen out of a predetermined range, wherein the defect information corresponds to the focus start position in the focus servo control.

With this configuration, in which the defective information is recorded in the memory, for example, reprocessing or determination of a defective workpiece can be performed based upon the defective information.

The photoresist layer processing method as described above may also be configured to stop all controlling operations when a distance at which the optical component is short of an in-focus position thereof, as determined during the focus servo control, has fallen out of a predetermined range.

With this configuration, no-yield processing can be avoided, and also the processing can be resumed from the position at which successful execution of the focus servo control has become impossible.

In the photoresist layer processing method as described above, the photoresist layer may be a layer formed of a thermally deformable heat mode material.

With this feature, holes can be formed in the photoresist layer merely by applying a laser beam to the photoresist layer.

The photoresist layer processing method as described above can be utilized in a method for manufacturing a patterned casting. The method for manufacturing a patterned casting, as yet another aspect of the present invention, comprises utilizing a pattern of holes formed in the photoresist layer by the above-described photoresist layer processing method, to manufacture a patterned casting on which a shape corresponding to the pattern of holes is formed.

With this configuration, in the photoresist layer processing process included in the method for manufacturing a patterned casting, the focus servo control can be stabilized more quickly. Thus, the photoresist layer can be processed satisfactorily, and the resulting patterned casting can be a satisfactorily processed one.

According to one or more aspects of the present invention, the position of the optical component is retained at a predetermined position for a period starting from a time when the laser beam has reached a focus stop position on an object until the laser beam reaches a focus start position on a subsequent object. Therefore, the position of the optical component relative to a subsequent object can be retained in a position close to the normal position, so that the focus servo control can be stabilized more quickly.

The above aspects and advantages, other advantages and further features of the present invention will be more apparent by a detailed description of illustrative, non-limiting embodiments of the present invention, which will be given below with reference to the accompanying drawings.

### BRIEF DESCRIPTION OF THE DRAWINGS

FIG. 1 is a perspective view showing an apparatus for implementing a photoresist layer processing method according to an illustrative embodiment of the present invention.

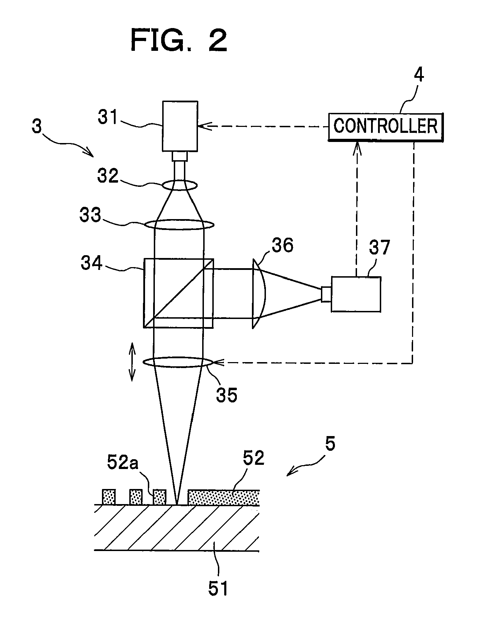

FIG. 2 is a schematic diagram showing a laser beam illumination device.
FIG. 3 includes (a) a block diagram showing a controller, (b) a map in which a focusing module performs a lookup, and (c) a map in which an output regulation module performs a lookup.

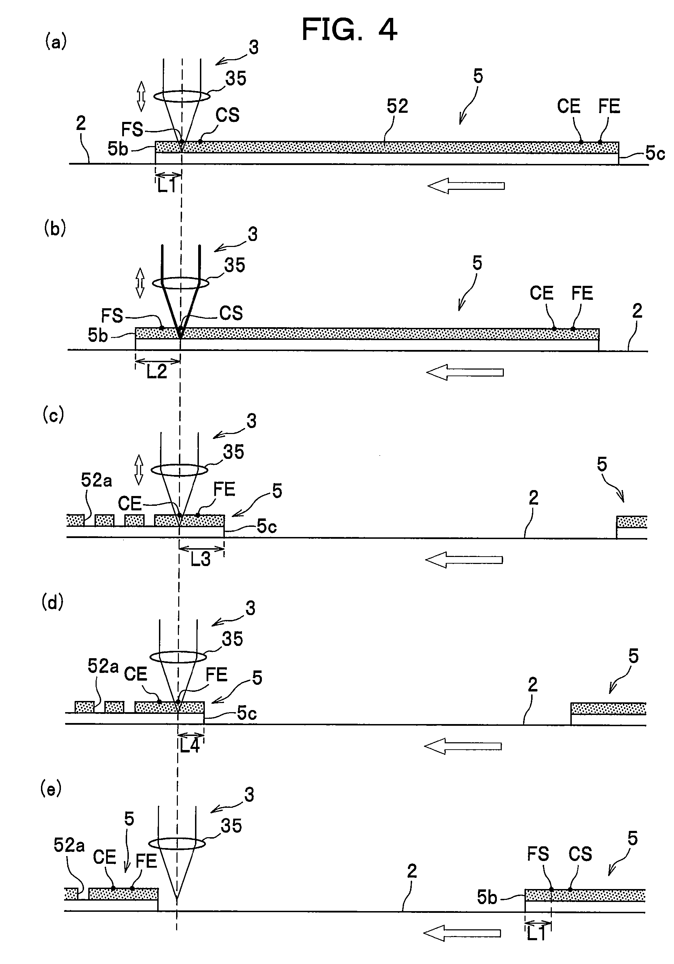

FIG. 4 includes (a) a sectional view showing the state as realized when a laser beam illumination device has reached a focus start position, (b) a sectional view showing the state as realized when the laser beam illumination device has reached a processing start position, (c) a sectional view showing the state as realized when the laser beam illumination device has reached a processing stop position, (d) a sectional view showing the state as realized when the laser beam illumination device has reached a focus stop position, and (e) a sectional view showing the state in which the position of an objective lens is retained between two workpieces.
FIG. 5 is an explanatory diagram showing a relationship between a synchronizing signal and processing signals.
FIG. 6 is an explanatory diagram showing a focus error signal.
FIG. 7 is a table showing various conditions of examples implemented.

### MODE(S) FOR CARRYING OUT THE INVENTION

Next, embodiments of the present invention will be described in detail with reference made to the drawings where appropriate.

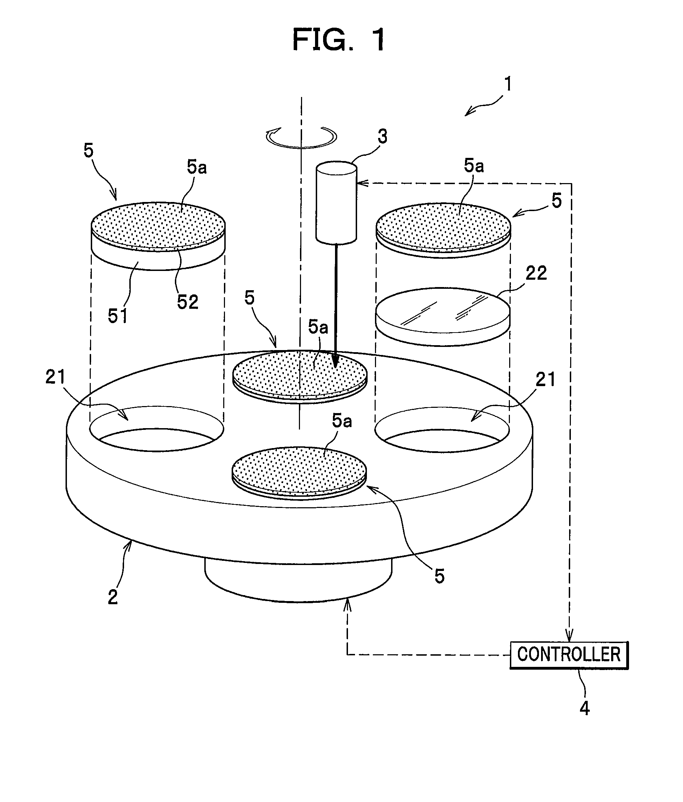

As shown in FIG. 1, a photoresist layer processing apparatus 1 is a device for implementing a photoresist layer processing method according to the present invention, and principally includes a supporting stage 2, a laser beam illumination device 3 and a controller 4.

The supporting stage 2 is a circular plate-like stage configured to rotate at a predetermined rotation speed, and operated under control of the controller 4 on an as appropriate basis. On a front side of the supporting stage 2, a plurality (four) of recesses 21 each having a shape of a cylinder with a bottom and configured to support disc-like workpieces 5 as an example of objects are formed in positions arranged in a circumferential direction and spaced out at predetermined intervals, such that the recesses 21 do not overlap the center of rotation of the supporting stage 2. Accordingly, when the supporting stage 2 is rotated, the plurality of workpieces 5 revolve around the center of rotation of the supporting stage 2.

The upper limit value of the diameter of the supporting stage 2 is preferably 2 m or less, more preferably 1.5 m or less, and further preferably 1 m or less. The lower limit value of the diameter is preferably 5 cm or more, and more preferably 10 cm or more. Since the arrangement of the workpieces 5 in positions closer to the circumference of the supporting stage 2 makes the processing speed faster, such arrangement is preferable. To be more specific, the workpieces may be arranged preferably in positions 5 % or more of the radius of the supporting stage 2 distanced from the center of rotation of the supporting stage 2, more preferably in positions 10 % or more of the radius distanced from the center of rotation, and further preferably in positions 20 % or more of the radius distanced from the center of rotation.

Each workpiece 5 is configured to include a disc-like substrate 51 and a photoresist layer 52 formed on the substrate 51. The photoresist layer 52 according to the present embodiment is a layer made of a material which is capable of being, once illuminated with intense light, deformed by heat resulting from conversion of the light to have a hole formed therein, or equivalently, a layer of so-called heat mode type photoresist material. Specific examples of the photoresist layer 52 will be detailed later.

A plurality (four) of workpieces 5 configured as described above are prepared and set in the plurality of recesses 21, respectively, of the supporting stage 2. In this step, in order that a position of the front surface 5a (*i.e*., height) of each workpiece 5 falls within tolerance as predetermined, if a workpiece 5 thinner than a standard type workpiece 5 is set, the height of the surface 5a thereof is adjusted by means of a spacer 22.

The laser beam illumination device 3 is a device for illuminating each workpiece 5 while a focus servo control is being effected under which an objective lens 35 as one example of an optical component thereof is moved based on reflected light received from the workpiece 5, and is configured to be movable in a radial direction of the supporting stage 2. To be more specific, the laser beam illumination device 3 includes a laser beam source 31, a first lens 32, a second lens 33, a semitransparent mirror 34, an objective mirror 35, a cylindrical lens 36 and a detector 37.

The laser beam source 31 is configured to emit a laser beam of which an output is regulated by the controller 4.

The first lens 32 is configured to enlarge a beam diameter of a laser beam emitted from the laser beam source 31, and located in a position downstream of the laser beam source 31 (downstream along a direction of travel of the laser beam).

The second lens 33 is configured to convert a laser beam of which the beam diameter has been enlarged by the first lens 32 into a parallel ray bundle, and located in a position downstream of the first lens 32.

The semitransparent mirror 34 is located in a position downstream of the second lens 33, and configured to transmit a laser beam emitted from the laser beam source 31, and to reflect a laser beam coming back from the opposite direction into a predetermined direction (substantially perpendicular to an optical-axis direction along which the incoming laser beam travels).

The objective lens 35 is configured to converge a laser beam which has transmitted the semitransparent mirror 34, and located in a position downstream of the semitransparent mirror 34. The objective lens 35 is configured to reciprocate in the optical-axis direction by a drive system operated under control of the controller 4 on an as appropriate basis. As the drive system therefor, for example, a known voice coil motor may be employed.

The cylindrical lens 36 is a lens shaped like a segment of a cylinder, and serves as a lens only in one direction. This cylindrical lens 36 is located on a path along which a laser beam reflected by the semitransparent mirror 34 travels.

The detector 37 is located in a position downstream of the cylindrical lens 36, and configured to serve a function of detecting a laser beam converged by the cylindrical lens 36 using four divisional optical sensors. A quantity of light of the laser beam detected by each optical sensor of the detector 37 is outputted to the controller 4.

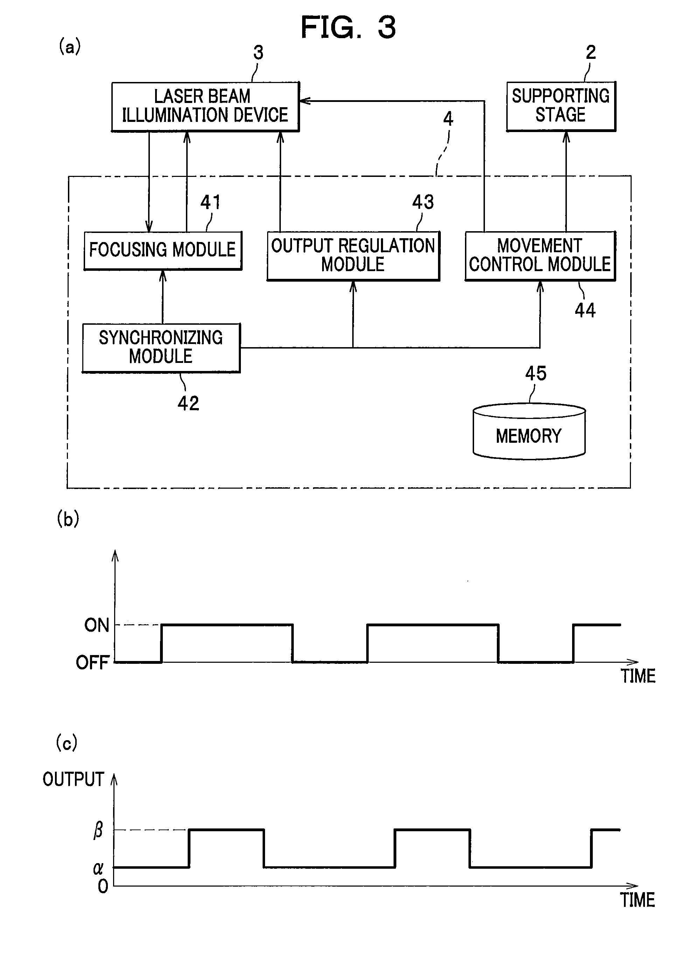

The controller 4 includes a CPU, a ROM, a RAM, a communication device, and other known hardware components (not shown). In the following description, referring to FIG. 3, that is a block diagram in which the hardware described above or the CPU having a program loaded from the ROM are illustrated as functional blocks, a detailed configuration of the controller 4 will be described.

As shown in FIG. 3 (a), the controller 4 includes a focusing module 41, a synchronizing module 42, an output regulation module 43, a movement control module 44 and a memory 45.

The focusing module 41 is configured to serve functions of turning ON and OFF the focus servo control based on focus control information stored previously in the memory 45, and retaining the position of the objective lens 35 at the position where the objective lens 35 is located at the time of turning OFF the focus servo control. To be more specific, for example, a circuit adapted to exercise the focus servo control based on reflected light is turned OFF by toggling a switch off, and the position of the objective lens 35 is retained at the position where it is located at that time by turning on a circuit adapted to retain an electric current passing through the drive system for driving the objective lens 35.

More specifically, the focusing module 41 is configured to exercise a control as described above based on a map (focus control information) as shown in FIG. 3 (b). In this map, the times when to switch the ON and OFF of the focus servo control are set at points of time corresponding to a focus start position FS and a focus stop position FE on the workpiece *5 (see* FIG. 4). In this embodiment, the focus start position FS and the focus stop position FE are set on a spiral track of a laser beam illumination spot moving on the surfaces of the supporting stage 2 and the plurality of workpieces 5 placed therein by rotation of the supporting stage 2 and movement of the laser beam illumination device 3.

The focusing module 41 exercises control in synchronization with the movement control module 44 (which will be described later) based on a synchronizing signal outputted from the synchronizing module 42; thus, with the help of this configuration, when the laser beam illumination device 3 reaches an initial position relative to the supporting stage 2 after the supporting stage 2 becomes stably rotated, the focusing module 41 starts its ON/OFF control of the focus servo control.

When the laser beam reaches a focus start position FS (*see* FIG. 4 (a)) on the workpiece 5, the focusing module 41 starts the focus servo control as described above, based on an astigmatic method. To be more specific, the focusing module 41 , during its focus servo control, operates to determine the position of the objective lens 35 based on a detection value outputted from the detector 37, and causes the objective lens 35 to move by outputting to the drive system an electric current corresponding to the distance of movement such that the position of the objective lens 35 comes to its in-focus position (a predetermined position fit for forming a hole having a predetermined diameter in the photoresist layer 52). Hereupon, when the objective lens 35 is in the in-focus position, the laser beam exhibits a perfect circle on the four divisional optical sensors, and thus the obtained value of operation becomes 0; when the objective lens 35 is shifted from the in-focus position, the laser beam exhibits a longitudinally or laterally oblong elliptical figure on the four divisional optical sensors, and thus the obtained value of operation becomes a positive or negative value.

When the laser beam reaches a focus stop position FE (*see* FIG. 4 (d)) on the workpiece 5, the focusing module 41 stops the focus servo control, and retains the position of the objective lens 35 at the position where it is located at that time.

The synchronizing module 42 is configured to serve a function of always outputting a synchronizing signal to the focusing module 41, the output regulation module 43 and the movement control module 44.

The output regulation module 43 is configured to serve a function of changing an output of the laser beam by controlling the laser beam source 31 based on processing information stored previously in the memory 45. To be more specific, the output regulation module 43 is configured to change the output of the laser beam based on a map (processing information) as shown in FIG. 3 (c). In this map, the times when to switch the laser output are set at points of time corresponding to the processing start position CS and the processing stop position CE on the workpiece 5 (*see* FIG. 4). In this embodiment, the processing start position CS and the processing stop position CE are set on a spiral track of a laser beam illumination spot moving on the surfaces of the supporting stage 2 and the plurality of workpieces 5 placed therein by rotation of the supporting stage 2 and movement of the laser beam illumination device 3.

The output regulation module 43 exercises control in synchronization with the focusing module 41 based on a synchronizing signal outputted from the synchronizing module 42, and is thereby configured to regulate the output of the laser beam such that the output of the laser beam becomes a predetermined value α when the focus servo control starts, and the output of the laser beam is raised to a value β greater than the predetermined value α after a predetermined period of time elapses (when the processing start position CS is reached). Further, the output regulation module 43 is configured to restore the output of the laser beam to the predetermined value α when a predetermined period of time elapses (when the processing stop position CE is reached) since the output of the laser beam is raised to the value β.

Moreover, the output regulation module 43 exercises an ON/OFF control on the laser beam source 31 (or a shutter arranged on an optical axis along which the laser beam travels) based on hole information stored previously in the memory 45 when the output of the laser beam is raised to and maintained at a value greater than the output (α) of the laser beam outputted at the time of starting the focus servo control as described above. In accordance with this process, a predetermined pattern of holes 52a (*see* FIG. 4 (c)) are formed with a laser beam at predetermined spots in the photoresist layer 52.

The movement control module 44 is configured to serve a function of controlling the rotation of the supporting stage 2 and the movement of the laser beam illumination device 3 in the radial direction based on a program stored previously in the memory 45. The movement control module 44 is configured to start the rotation of the supporting stage 2 and the radial movement of the laser beam illumination device 3 based on a synchronizing signal received from the synchronizing module 42.

The memory 45 is configured to store the focus start position FS, the focus stop position FE, the processing start position CS and the processing stop position CE as described above, as the times when to switch the ON and OFF of the focus servo control (*see* FIG. 3(b)) or the times when to switch the laser output (*see* FIG. 3(c)) as described above. The memory 45 is also configured to store programs for control on the supporting stage 2 and the laser beam illumination device 3. Hereupon, the focus start position FS, the focus stop position FE, the processing start position CS and the processing stop position CE are positions that are set on a spiral track of a laser beam illumination spot moving on the surfaces of the supporting stage 2 and the plurality of workpieces 5 placed therein by the rotation of the supporting stage 2 and the radial movement of the laser beam illumination device 3, and these positions are set for each workpiece 5. To be more specific, as shown in FIG. 4 (a), a position spaced a distance L1 short of a front end 5b of each workpiece 5 located at a leading edge thereof in the direction of movement of the workpiece 5 is set to the focus start position FS. Similarly, as shown in FIG. 4 (b), a position spaced a distance L2 (longer than the distance L1) short of the front end 5b of each workpiece 5 is set to the processing start position CS. Similarly, as shown in FIG. 4 (c), a position spaced a distance L3 short of a rear end 5c of each workpiece 5 located at a trailing edge thereof in the direction of movement of the workpiece 5 is set to the processing stop position CE. Similarly, as shown in FIG. 4 (d), a position spaced a distance L4 (shorter than the distance L3) short of the rear end 5c of each workpiece 5 is set to the focus stop position FE.

In this embodiment, the distances L1, L4 are set such that the laser beam in its entirety is applied to the workpiece 5 (i.e., the whole illumination spot falls within the workpiece 5). To be more specific, if the spot diameter of the laser beam is 1 µm, the distances L1, L4 may preferably be set to 1 µm or more. More specifically, the lower limit values of the distances L1, L4 are preferably 1 µm or more, more preferably 10 µm or more, and further preferably 100 µm or more. The lower limit values set as mentioned just above make it possible to apply the whole laser beam to a workpiece 5 without fail, and thus the focus servo control can be exercised effectively. Furthermore, the upper limit values of the distances L1, L4 are preferably 10 mm or less, more preferably 5 mm or less, and further preferably 1 mm or less. The upper limit values set as mentioned just above make it possible to broaden a processing area on the workpiece 5, thus increasing the productivity.

The focus start position FS, the focus stop position FE, the processing start position CS and the processing stop position CE are set in a portion of each workpiece 5 that is not less than 1 µm short of an inner edge thereof, *i.e*., an edge closer to a center of rotation of the supporting stage 2, and that is not less than 1 µm short of an outer edge thereof, *i.e*., an edge farthest from the center of rotation of the supporting stage 2. With this setting, the laser beam is applied to the portion that is not less than 1 µm short of the inner edge and not less than 1 µm short of the outer edge, and portions of 1-µm range from the inner and the outer edges are not to be processed.

The lower limit values of the ranges of the portions not to be processed but to be left at the inner and outer edges are preferably 1 µm or more, more preferably 10 µm or more, and further preferably 100 µm or more. The lower limit values set as mentioned just above make it possible to apply the whole laser beam to a workpiece 5 without fail, and thus the focus servo control can be exercised effectively. Furthermore, the upper limit values of the ranges of the portions not to be processed are preferably 10 mm or less, more preferably 5 mm or less, and further preferably 1 mm or less. The upper limit values set as mentioned just above make it possible to broaden a processing area on the workpiece 5, thus increasing the productivity.

Next, a laser exposure method and a photoresist layer processing method according to the present invention will be described.

First, the supporting stage 2 is caused to rotate, and a weak laser beam having a predetermined value α is emitted from the laser beam illumination device 3. After the rotation of the supporting stage 2 becomes stable, the laser beam reaches the focus start position FS as shown in FIG. 4 (a), and then the controller 4 starts a focus servo control (control start step).

Thereafter, when the laser beam reaches the processing start position CS as shown in FIG. 4 (b), the controller 4 increases the output of the laser beam, and starts the processing with the laser beam (processing start step). Through this step, holes 52a (a pattern of holes) as shown in FIG. 4 (c) are formed in the photoresist layer 52 of the workpiece 52. In FIG. 4, the laser beam of which the output has been increased is represented by a thick line.

When the laser beam reaches the processing stop position CE as shown in FIG. 4 (c), the controller 4 lowers the output of the laser beam, and stops the processing with the laser beam (processing stop step). Thereafter, when the laser beam reaches the focus stop position FE as shown in FIG. 4 (d), the controller 4 stops the focus servo control (control stop step), and retains the objective lens 35 at the position where it is located at that time (retaining step). As a result, the objective lens 35 is retained at that position for a period starting from a time when the focus stop position FE has been reached until the focus start position FS on the subsequent workpiece 5 has been reached, as shown in FIG. 4 (e). During this step, the laser beam is continuously outputted from the laser beam illumination device 3, while the controller 4 neglects information on reflected light and retains the position of the objective lens 35.

After the holes 52a are formed in the photoresist layer 52, etching is further conducted to make holes in the substrate 51 whereby a predetermined pattern of recessed portions (pit pattern) corresponding to the holes 52a is formed on the substrate 51, to manufacture the substrate 51 for use in an information recording medium (patterned casting). Further, a stamper (patterned casting) or the like to which a pattern of holes 52a on the photoresist layer 52 are transferred may be manufactured by vapor deposition, plating, etc.

According to the present embodiment as described above, the following advantageous effects can be achieved.

Since the position of the objective lens 35 is retained for a period starting from a time when the laser beam has reached the focus stop position FE on the workpiece 5 until the laser beam reaches the focus start position FS on the subsequent workpiece 5, the position of the objective lens 35 can be maintained at the position close to its in-focus position for the subsequent workpiece 5 as well, so that the focus servo control can be stabilized more quickly. Furthermore, since the processing of the photoresist layer 52 with a laser beam is carried out with the focus servo control being effectively exercised over each workpiece 5, the photoresist layer 52 of each workpiece can be processed precisely.

Since the laser beam is applied in its entirety to the workpiece 5 in the focus start position FS and the focus stop position FE, the potential risk, such as failure to properly exercise the focus servo control, which would be caused in the event that the laser beam is applied partially off the workpiece 5, can be prevented.

Since emission of the laser beam during the retaining step is designed to continue uninterruptedly, the laser beam can be emitted more stably when the focus servo control is started for the subsequent workpiece 5, in comparison with the method in which emission of the laser beam during the retaining step is stopped.

Since the objective lens 35 is retained at the position which is the position of the objective lens 35 located when the focus servo control is stopped, any useless motion of the objective lens 35 can be avoided, and thus the wearing of a drive system therefor can be suppressed.

Since a plurality of workpieces 5 are caused to revolve by rotating the supporting stage 2, the plurality of workpieces 5 can be moved relative to the laser beam illumination device 3 with a simple configuration.

Since the laser beam is applied to a portion of each workpiece 5 which is defined to range between a position not less than 1 µm inside from an edge closer to the axis of rotation of the supporting stage 2 and a position not less than 1 µm inside from an edge farthest from the axis of rotation of the supporting stage 2, the potential risk, such as failure to properly exercise the focus servo control as a result of application of the laser beam partially off the workpiece 5, which would be caused in the event that the workpiece 5 has a chipped portion at its edge, can be prevented.

Since the photoresist layer 52 is formed of a thermally deformable heat mode material, holes 52a may be formed in the photoresist layer 52 merely by illuminating the photoresist layer 52 with a laser beam.

The present invention is not limited to the above-described embodiment, but can be utilized in various modes as will be exemplified below.

In the above-described embodiment, the emission of the laser beam is continued uninterruptedly, but the present invention is not limited to this embodiment, the emission of the laser beam may be continued intermittently. In this alternative configuration, the emission of the laser beam from the laser beam illumination device may preferably be continued intermittently during the control start step, the control stop step and the retaining step. With this configuration, the control on the laser beam illumination device may be made simple, and thus carried out simply by always continuing to emit the laser beam intermittently, so that the control efficiency can be improved. Furthermore, in this embodiment, it is preferable that the timing of intermittent emission of the laser be synchronized with a synchronizing signal outputted in accordance with the rotation of the spindle to thereby precisely control the relative positions between the processed tracks adjacent to each other in the radial direction of the supporting stage. Hereupon, the synchronizing signal refers to a signal outputted periodically so as to arrange the positions neatly.

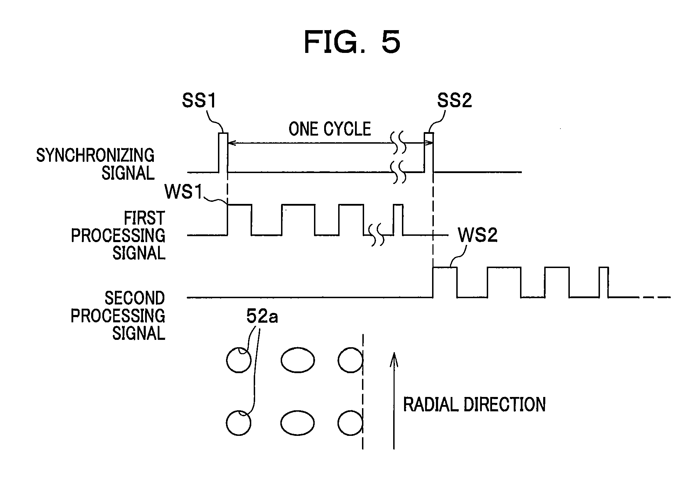

To be more specific, in a case where a synchronizing signal is outputted at each one cycle in which the supporting stage makes one full rotation, as shown in FIG. 5, for example, a first processing signal WS1 for processing of the outermost one cycle of the spiral tracks to be processed is outputted in synchronization with a predetermined first synchronizing signal SS1, a second processing signal WS2 for processing of the second one cycle adjacent to the outermost one cycle of the spiral tracks to be processed is outputted in synchronization with a second synchronizing signal SS2 outputted subsequently to the first synchronizing signal. With this configuration, the positions of holes 52a adjacent to each other in the radial direction of the supporting stage can be aligned neatly (or maintained in a predetermined relation). If the synchronizing signal is outputted only once in each one cycle, the displacements would possibly occur due to irregularities in rotation. Therefore, it is preferable that the synchronizing signal is outputted twice or more times in one cycle. The number of times (the number of pulses) of the synchronizing signal outputted in one cycle is preferably 16, more preferably 256, and further preferably 1,024.

In the above-described embodiment, the objective lens 35 is retained at a position of the objective lens 35 located when the focus servo control is stopped, but the present invention is not limited to this embodiment. For example, the objective lens 35 may be moved to a position corresponding to a surface of a workpiece 5 to be exposed next and retained at that position. That is, information on the position of the surface of each workpiece 5 may be stored previously in the memory 45, and the objective lens 35 may be moved based on this information after the focus servo control is stopped. With this configuration, even if the surface positions of the workpieces can not be so set as to come in substantially the same position, the focus servo control can be exercised properly over the subsequent workpiece 5 because the objective lens 35 is moved to and retained at the position corresponding to the surface of the subsequent workpiece 5 which is to be illuminated next.

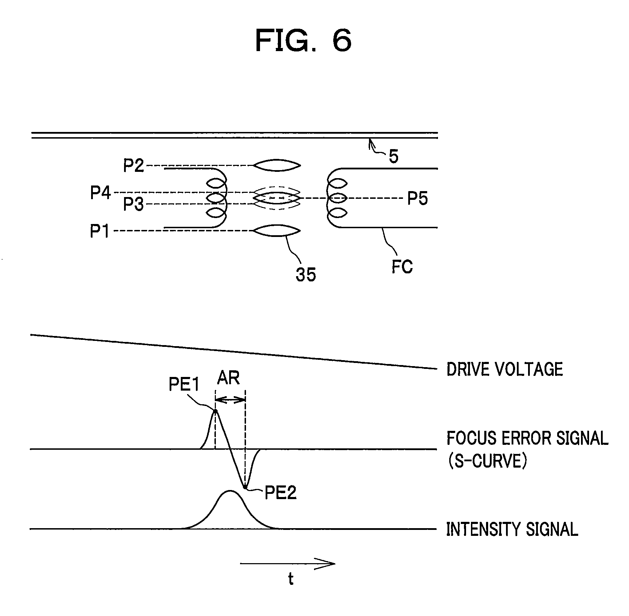

In the above-described embodiment, the objective lens 35 is retained at a position of the objective lens 35 located when the focus servo control is stopped, but the present invention is not limited to this embodiment. For example, as shown in FIG. 6, when the focus servo control is stopped, the objective lens 35 may be moved to a position corresponding to an interval between peaks PE1, PE2 of an S-curve of a focus error signal and retained at that position. Hereupon, the "focus error signal" refers to a known signal curved like a letter S as obtained based on reflected light for example when the objective lens 35 is moved simply toward a workpiece 5 (when the objective lens 35 is moved from the position P1 to the position P2 by lowering a driving voltage supplied to the focus drive coil FC with a predetermined gradient) without the focus servo control being effected. The focus error signal exhibits an output of 0 when the objective lens 35 is positioned at the in-focus position P5 (when the light intensity signal becomes the maximum). As the objective lens 35 moves with reference to the in-focus position P5, toward the workpiece 5 or away from the workpiece 5, the focus error signal changes within the range AR, proportionately toward the peak PE1 or PE2. The position corresponding to an interval between the peaks PE1 and PE2 is, for example, a position in the range between the positions P3 and P4 shown in the drawing. Thus, if the objective lens 35 is retained at any position within the range between the positions P3 and P4, the focus servo control on the subsequent object can be exercised effectively.

In the above-described embodiment, the processing start position CS is set at a position rearward of the focus start position FS with respect to the moving direction of the workpieces 5 and the processing stop position CE is set at a position forward of the focus stop position FE, but the present invention is not limited to this embodiment. For example, the processing start position CS may be set at the same position as of the focus start position FS, and the processing stop position CE may be set at the same position as of the focus stop position FE. In other words, the focus servo control and the processing may be started or stopped synchronously.

In the above-described embodiment, the laser beam output is increased to start the processing when the laser beam illumination device 3 has reached the processing start position CS, but the present invention is not limited to this embodiment. For example, in the above-described embodiment, without the processing start position CS being set, the laser beam output may be increased to a level greater than that of the laser beam outputted during the focus servo control to start the processing when a distance at which the objective lens 35 is short of an in-focus position thereof, as determined during the focus servo control started at the focus start position FS, has fallen within ±300 µm. That is, the output is not regulated based on the map shown in FIG. 3 (c), but the control exercised during the focus servo control may be such that determination as to whether or not the distance to the in-focus position has fallen within ±300 µm is made and the laser beam output is increased when the distance has fallen within ±300 µm.

With this configuration, since the processing is started when the objective lens 35 has been positioned substantially in the in-focus position, a good processed shape can be formed in the photoresist layer 52 from a point of time when the processing is started. Accordingly, low-yield processing can be avoided, and the power consumption increased according to the increase in the laser output can be reduced. The distance at which the objective lens 35 is short of its in-focus position as the reference for determination as to whether to start the processing is preferably ±100 µm, more preferably ±50 µm, and further preferably ±10 µm.

During the focus servo control in the above-referenced embodiment, when the distance at which the objective lens 35 is short of its in-focus position has fallen out of a predetermined range, a processing prohibition control may be executed in which a laser beam output is maintained at or changed to a level of the laser beam outputted during the focus servo control. To be more specific, if the distance at which the objective lens 35 is short of its in-focus position falls out of the predetermined range during a period from the time of starting the focus servo control until the time of starting the processing, the laser beam output may be maintained at the level of the laser beam outputted at the time of starting the focus servo control. On the other hand, if the distance at which the objective lens 35 is short of its in-focus position falls out of the predetermined range during the processing, the laser beam output may be lowered to the level of the laser beam outputted at the time of starting the focus servo control.

With this configuration, when the distance at which the objective lens 35 is short of its in-focus position has fallen out of the predetermined range and the execution of the focus servo control becomes impossible, the laser beam output is maintained at or changed to the level of the laser beam outputted during the focus servo control to thereby prohibit the processing; consequently, useless increase in the laser output and the low-yield processing can be restricted.

During the focus servo control in the above-referenced embodiment, when the processing prohibition control is executed, at least one of the supporting stage 2 and the laser beam illumination device 3 may be moved relative to each other, to locate the laser beam back to the same position as a focus start position FS that is being set at a time of execution of the processing prohibition control. With this configuration, when the execution of the focus servo control becomes impossible, the focus servo control is resumed from the same focus start position FS to perform processing, and thus production of defectives can be reduced.

During the focus servo control in the above-referenced embodiment, when the distance at which the objective lens 35 is short of its in-focus position has fallen out of the predetermined range, defect information corresponding to the focus start position FS in the focus servo control may be recorded in the memory 45. With this configuration, since the defective information is recorded in the memory 45, for example, reprocessing or determination of a defective workpiece can be performed based on the defective information.

During the focus servo control in the above-referenced embodiment, when the distance at which the objective lens 35 is short of its in-focus position has fallen out of the predetermined range, all controlling operations may be stopped. With this configuration, no-yield processing can be avoided, and also the processing can be resumed from the position at which successful execution of the focus servo control has become impossible.

In the above-described embodiment, the laser exposure method is utilized in a method for processing a photoresist layer 52, but the present invention is not limited to this embodiment; for example, the laser exposure method according to the present invention may be utilized in writing/reading of a test piece as in the conventional art.

In the above-described embodiment, the plurality of workpieces 5 are caused to revolve, but the present invention is not limited to this embodiment; the movement of the plurality of workpieces 5 may be made linearly along the surfaces thereof (in a direction of arrangement of the plurality of workpieces 5).

In the above-described embodiment, the objective lens 35 is adopted as an optical component which is driven under focus servo control, but the present invention is not limited to this embodiment; for example, the first lens 32 as in the above-described embodiment may be adopted.

In the above-described embodiment, the focus servo control is exercised based on an astigmatic method, but the present invention is not limited to this embodiment; for example, the focus servo control may be exercised based on a Foucault method or the like.

In the above-described embodiment, each workpiece 5 adopted is circular in shape, but the present invention is not limited to this embodiment; for example, the workpiece 5 may have a polygonal shape. Moreover, the number of workpieces 5 may be any number. Furthermore, the size and shape of workpieces placed on the same supporting stage 2 may be different from one another. It is to be understood that the inner edge and the outer edge of a workpiece which has a polygonal shape are its portions closest to and farthest from the axis of rotation of the supporting stage, respectively.

The material for use in the photoresist layer 52 is not limited to the heat mode type material, but may be a photon mode type material or a material which is subject to change in its physical properties by exposure to light and becomes capable of being resolved by a developing solution. Specific examples of the heat mode type photoresist material, and the conditions for processing the photoresist layer are as follows.

The heat mode type photoresist material which may be adopted includes recording materials as hitherto used generally in the recording layer of optical discs or the like; for example, recording materials such as cyanine-based, phthalocyanine-based, quinone-based, squarylium-based, azulenium-based, thiol complex salt-based, and merocyanine-based recording materials may be used for our purpose.

The photoresist layer according to the present invention may preferably be of a dye type, which contains a dye as a photoresist material.

Therefore, the photoresist material contained in the photoresist layer may be selected from dyes or other organic compounds. It is to be understood that the photoresist material is not limited to organic material; that is, an inorganic material or a composite material of organic and inorganic materials may also be employed. With the organic materials, however, the coating process for forming a film can be performed easily by spin coating or spraying, and a material having a lower transition temperature is readily available; thus, the organic materials may be preferable. Further, amongst various organic materials, dyes whose light absorption can be controlled by varying their molecular design may be preferable.

Preferred examples of material for use in the photoresist layer may include methine dyes (cyanine dyes, hemicyanine dyes, styryl dyes, oxonol dyes, merocyanine dyes, etc.), large ring dyes (phthalocyanine dyes, naphthalocyanine dyes, porphyrin dyes, etc.), azo dyes (including an azo-metal chelate dye), arylidene dyes, complex dyes, coumarin dyes, azole derivatives, triazine derivatives, 1-aminobutadiene derivatives, cinnamic acid derivatives, quinophthalone dyes, etc. Of these, oxonol dyes, phthalocyanine dyes and cyanine dyes may be preferable.

This dye-type photoresist layer may preferably contain a dye having absorption in the range of exposure light wavelengths. Particularly, the upper limit of an extinction coefficient k indicating the amount of light absorption may preferably be 10 or less, more preferably 5 or less, still more preferably 3 or less, and most preferably 1 or less. On the other hand, the lower limit of the extinction coefficient k may preferably be 0.0001 or more, more preferably 0.001 or more, and still more preferably 0.1 or more. Setting the extinction coefficient k within the above range preferably makes the shapes of the holes uniform. The range of refractive indices of the photoresist layer is preferably 1.2 to 3.0, more preferably 1.3 to 2.5, and still more preferably 1.4 to 1.9.

It is to be understood, as described above, that the photoresist layer needs to have absorption of light in the range of exposure light wavelengths; with this in view, the selection of an appropriate dye and/or alteration of its structure may be made in accordance with the wavelength of the laser beam produced by the laser light source.

For example, in the case where the oscillation wavelength of the laser beam emitted from the laser light source is around 780 nm, it is advantageous to select dyes such as pentamechine cyanine dyes, heptamechine oxonol dyes, pentamethine oxonol dyes, phthalocyanine dyes, and naphthalocyanine dyes. Of these, phthalocyanine dyes or pentamethine cyanine dyes may be used preferably in particular.

In the case where the oscillation wavelength of the laser beam emitted from the laser light source is around 660 nm, it is advantageous to select dyes such as trimechine cyanine dyes, pentamethine oxonol dyes, azo dyes, azo-metal complex dyes, and pyrromethene complex dyes.

Further, in the case where the oscillation wavelength of the laser beam emitted from the laser light source is around 405 nm, it is advantageous to select dyes such as monomechine cyanine dyes, monomechine oxonol dyes, zero-mechine merocyanine dyes, phthalocyanine dyes, azo dyes, azo-metal complex dyes, porphyrin dyes, arylidene dyes, complex dyes, coumarin dyes, azole derivatives, triazine derivatives, benzotriazole derivatives, 1-aminobutadiene derivatives, and quinophthalone dyes.

Examples of preferred compounds for use in the photoresist layer (*i.e*., as a photoresist material) are shown below in the cases where the oscillation wavelength of the laser beam emitted from the laser light source is around 780 nm, around 660 nm, and around 405 nm, respectively. Compounds given by (I-1) to (I-10) in the following chemical formulae 1, 2 are suitable in the case where the oscillation wavelength of the laser beam is around 780 nm. Compounds given by formulae (II-1) to (II-8) in the chemical formulae 3, 4 are suitable in the case where the oscillation wavelength of the laser beam is around 660 nm, and compounds given by (III-1) to (III-14) in the chemical formulae 5, 6 are suitable in the case where the oscillation wavelength of the laser beam is around 405 nm. It is to be understood that the present invention is not limited to the case where these compounds are used as the photoresist material.

Examples of photoresist material in the case of laser oscillation wavelength around 780 nm

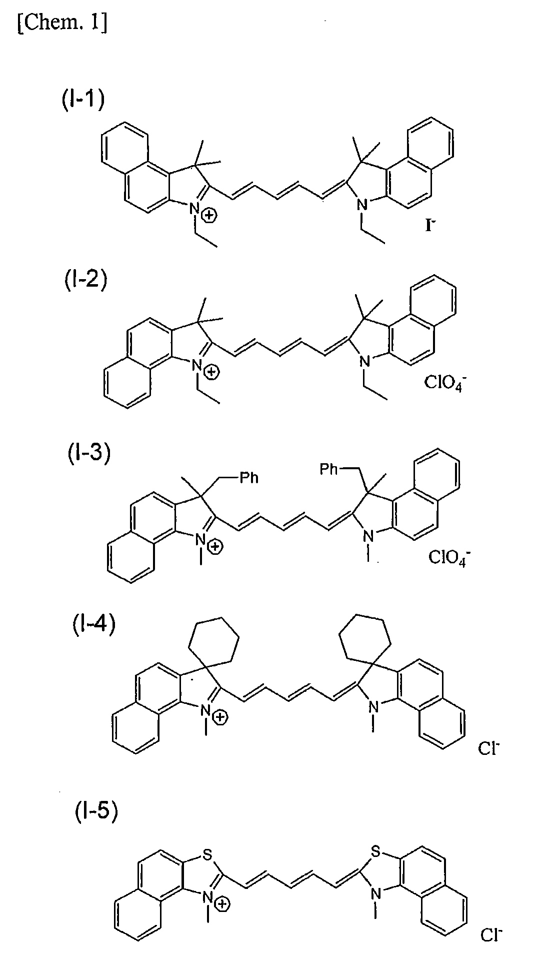

Examples of photoresist material in the case of laser oscillation wavelength around 780 nm

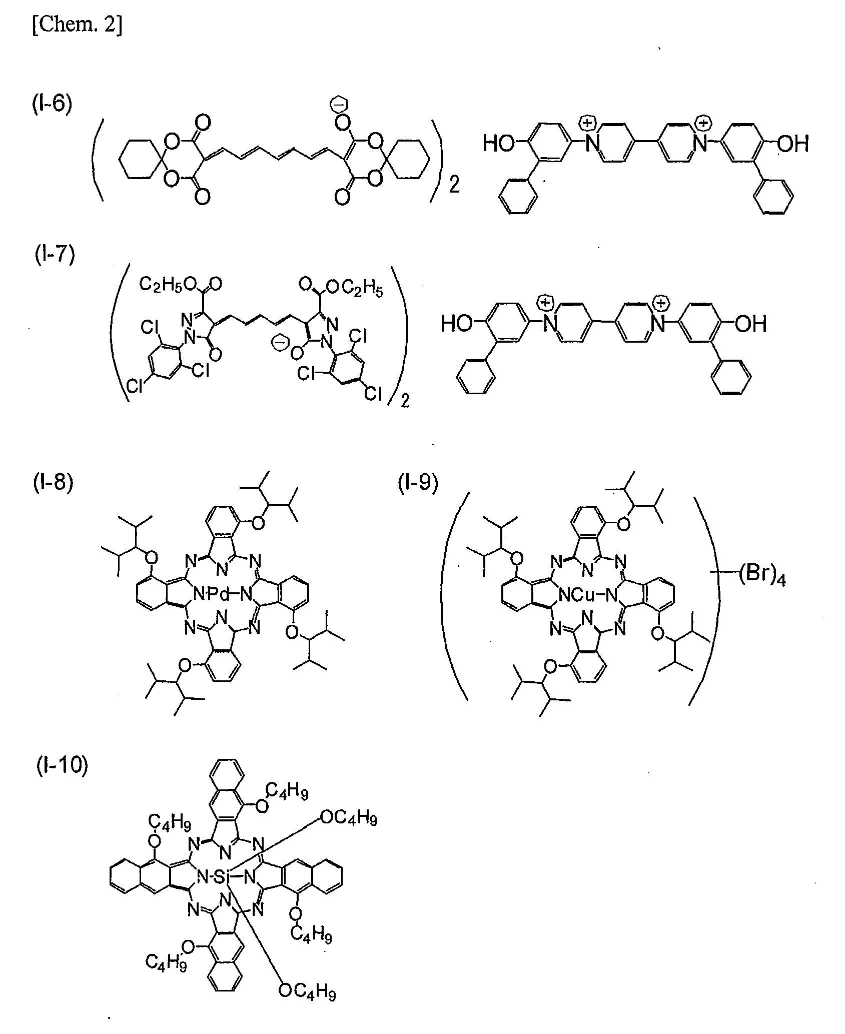

Examples of photoresist material in the case of laser oscillation wavelength around 660 nm

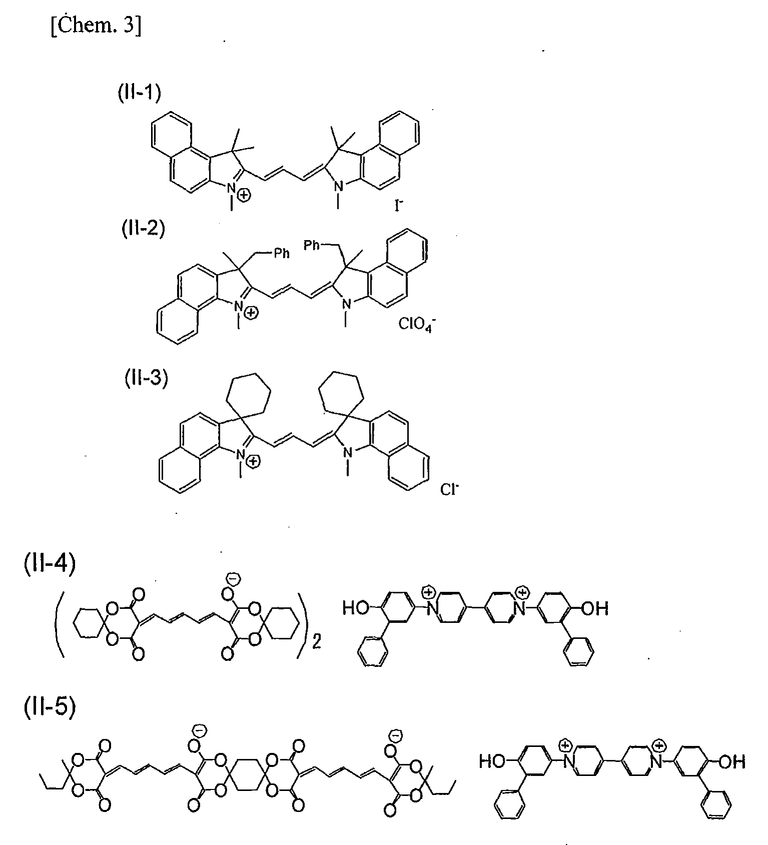

Examples of photoresist material in the case of laser oscillation wavelength around 660 nm

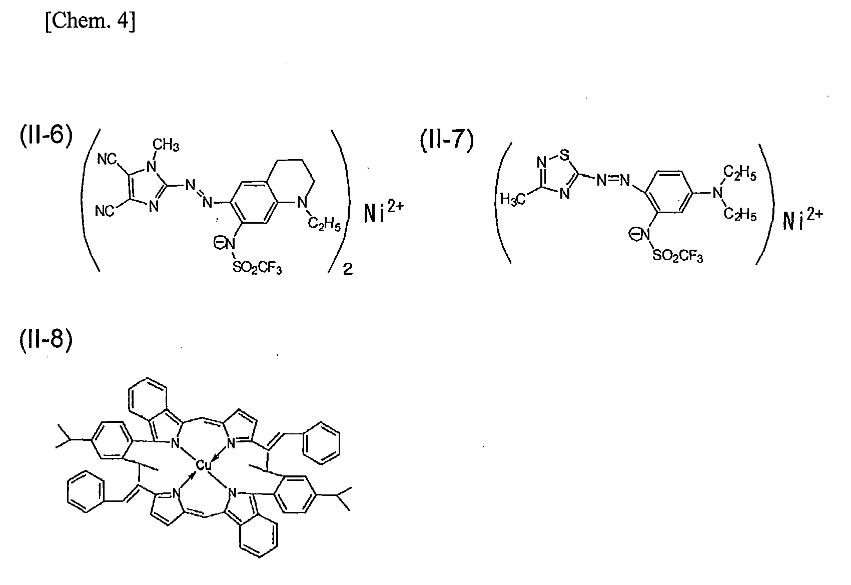

Examples of photoresist material in the case of laser oscillation wavelength around 405 nm

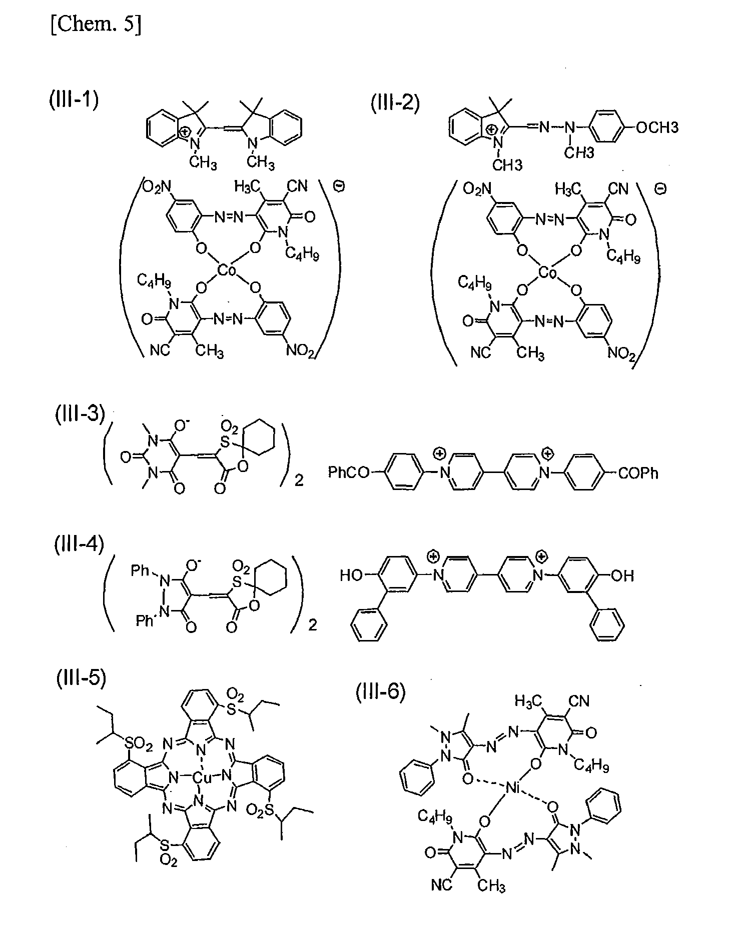

Examples of photoresist material in the case of laser oscillation wavelength around 405 nm

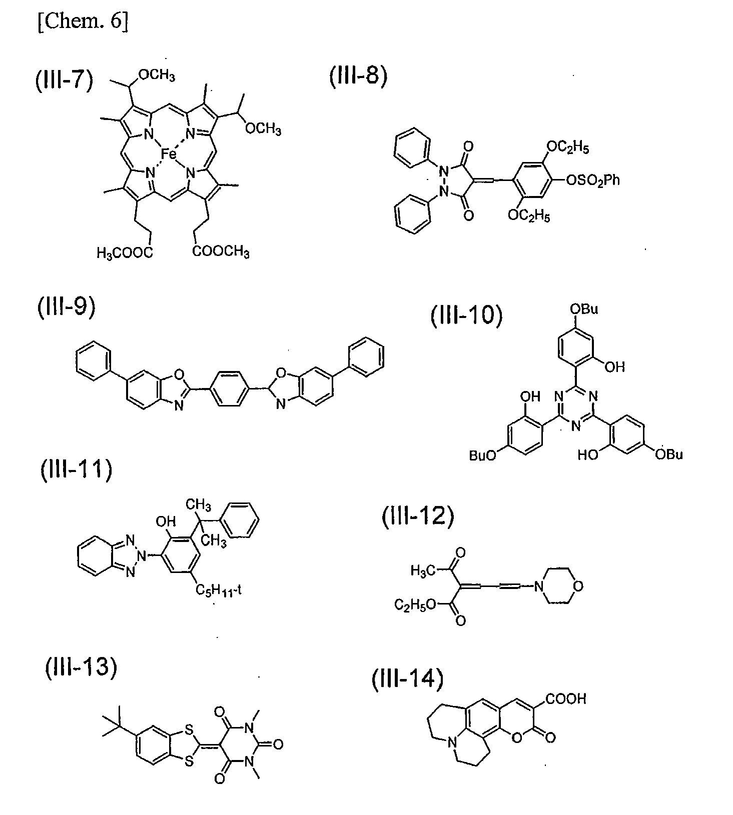

Dyes described in Japanese Laid-open Patent Applications, Publication (JP-A) Nos. 4-74690, 8-127174, 11-53758, 11-334204, 11-334205, 11-334206, 11-334207, 2000-43423, 2000-108513, and 2000-158818 can also preferably be used.

The dye-type photoresist layer may be formed by dissolving a dye in an adequate solvent along with a binding agent, etc. to prepare a coating liquid, then applying the coating liquid on a substrate to form a coating film, and thereafter drying the resulting coating film. In this process, the temperature of a surface on which the coating liquid is applied may preferably be in the range of 10-40 degrees centigrade. More preferably, the lower limit thereof may be 15 degrees centigrade or higher, still more preferably 20 degrees centigrade or higher, and particularly preferably 23 degrees centigrade or higher. Meanwhile, the upper limit thereof may be more preferably 35 degrees centigrade or lower, still more preferably 30 degrees centigrade or lower, and particularly preferably 27 degrees centigrade or lower. When the temperature of the coated surface is in the above ranges, uneven application of the coating and coating failure can be prevented, so that a thickness of the coating film can be made uniform.

Each of the upper and lower limits mentioned above may be arbitrarily combined with each other.

Here, the photoresist layer may be either mono-layered or multi-layered. In the case of the photoresist layer having a multi-layered configuration, the coating step is repeated plural times.

A concentration of the dye in the coating liquid is generally in the range of 0.01-30 mass percent, preferably in the range of 0.1-20 mass percent, more preferably in the range of 0.5-15 mass percent, and most preferably in the range of 0.5-10 mass percent.

Examples of the solvent for the coating liquid include: esters such as butyl acetate, ethyl lactate and cellosolve acetate; ketones such as methyl ethyl ketone, cyclohexanone, and methyl isobutyl ketone; chlorinated hydrocarbons such as dichloromethane, 1,2-dichloroethane and chloroform; amides such as dimethylformamide; hydrocarbons such as methylcyclohexane; ethers such as tetrahydrofuran, ethyl ether, and dioxane; alcohols such as ethanol, n-propanol, isopropanol, n-butanol, and diacetone alcohol; fluorinated solvents such as 2,2,3,3-tetrafluoropropanol; and glycol ethers such as ethylene glycol monomethyl ether, ethylene glycol monoethyl ether and propylene glycol monomethyl ether. Fluorinated solvents, glycol ethers and ketones are preferable. Particularly preferable are fluorinated solvents and glycol ethers. Further preferable are 2,2,3,3-tetrafluoropropanol and propylene glycol monomethyl ether.

Taking the solubility of the dye used in the solvents into consideration, the above solvents may be used singly or in a combination of two or more kinds thereof. Various kinds of additives such as an antioxidant, a UV absorbent, a plasticizer and a lubricant may be added in the coating liquid depending on the purpose.

Coating methods such as spray method, spin coating method, dip method, roll coat method, blade coat method, doctor roll method, doctor blade method, and screen printing method are applicable. Of these methods, the spin coating method is preferable in terms of its excellent productivity and easy controllability of the film thickness.

In order to form the photoresist layer better by the spin coating method, the dye may be dissolved in the organic solvent preferably in the range of 0.01-30 mass percent, more preferably in the range of 0.1-20 mass percent, further preferably in the range of 0.5-15 mass percent, and most preferably in the range of 0.5-10 mass percent. It is also preferable that the thermal decomposition temperature of the photoresist material be in the range of 150-500 degrees centigrade, and more preferably in the range of 200-400 degrees centigrade.

The temperature of the coating liquid at the time of coating may preferably be in the range of 23-50 degrees centigrade, more preferably in the range of 24-40 degrees centigrade, and particularly preferably in the range of 25-30 degrees centigrade.

In the case where the coating liquid contains a binding agent, examples of the binding agent include natural organic polymers such as gelatin, cellulose derivatives, dextran, rosin and rubber; and synthetic organic polymers including hydrocarbonic resins such as polyethylene, polypropylene, polystylene and polyisobutylene, vinyl resins such as polyvinylchloride, polyvinylidene chloride and polyvinylchloride-polyvinyl acetate copolymers, acrylic resins such as polymethyl acrylate and polymethyl methacrylate, and initial condensates of thermosetting resins such as polyvinyl alcohol, chlorinated polyethylene, epoxy resin, butyral resin, rubber derivatives and phenol formaldehyde resin. In the case where the binding agent is used together as a material for the photoresist layer, the amount of the binding agent used is generally in the range of 0.01-50 times the amount of dye (mass ratio), and preferably in the range of 0.1-5 times the amount of dye (mass ratio).

In order to increase the lightfastness of the photoresist layer, various antifading agents may be contained in the photoresist layer.

In general, a singlet oxygen quencher is used for the antifading agent. As examples of such singlet oxygen quencher, those described in published documents such as patent specifications hitherto known in the art can be used.

Specific examples of such patent specifications include: Japanese Laid-open Patent Applications, Publication (JP-A) Nos. 58-175693, 59-81194, 60-18387, 60-19586, 60-19587, 60-35054, 60-36190, 60-36191, 60-44554, 60-44555, 60-44389, 60-44390, 60-54892, 60-47069, 63-209995, and 4-25492; Japanese Examined Patent Applications, Publication (JP-B) Nos. 1-38680 and 6-26028; German Patent No. 350399; and Nippon Kagaku Kaishi, October (1992), p. 1141. The use amount of the antifading agent such as a singlet oxygen quencher relative to the amount of dye is generally in the range of 0.1-50 mass percent, preferably in the range of 0.5-45 mass percent, more preferably in the range of 3-40 mass percent, and particularly preferably in the range of 5-25 mass percent.

The photoresist layer may also be formed by any film-forming method such as evaporation, sputtering and CVD, which may be selected depending on the physical properties of the material to be used therein.

The dye to be used is such that a light absorptance thereof at the wavelength of a laser beam used in the processing of a pattern of holes is higher than those at the other wavelengths.

The wavelength at which the dye exhibits the peak absorption may not necessarily fall within the range of the wavelengths of visible light, but may be within the range of the wavelengths of the ultraviolet or infrared region.

The wavelength λw of the laser beam to be emitted to form a pattern of holes may be any wavelength as long as a sufficiently high laser power is obtained. For example, in the case where a dye is used for the photoresist layer, the wavelength may preferably be 1,000 nm or less, such as 193 nm, 210 nm, 266 nm, 365 nm, 405 nm, 488 nm, 532 nm, 633 nm, 650 nm, 680 nm, 780 nm, and 830 nm.

The laser beam may be a continuous light beam or pulsed light beam. However, it is preferable to use a laser beam whose emission intervals can be changed freely. For example, the use of a semiconductor laser is preferable. In the case where the laser beam is not directly on-off keyed, it is preferable that the laser beam is modulated using an external modulation element.

In order to increase the processing speed, a higher laser power is preferable. However, the higher the laser power, the higher scanning speed (speed for scanning the photoresist layer with the laser beam; for example, rotation speed of the supporting stage 2 in the above-described embodiment) is required. For this reason, taking the upper limit value of the scanning speed into consideration, the upper limit value of the laser power is preferably 100 W, more preferably 10 W, and still more preferably 5 W, and most preferably 1 W. Meanwhile, the lower limit value of the laser power is preferably 0.1 mW, more preferably 0.5 mW, and still more preferably 1 mW.

It is preferable that the laser beam excels in oscillation wavelength and coherency, and that the laser beam can be condensed to a spot size which is as small as the wavelength of the laser beam. Further, as a light exposure strategy (*i.e*., optical pulse illumination conditions for appropriately forming a pattern of holes), it is preferable that the strategy used for optical discs is employed. To be more specific, conditions required for the manufacture of optical discs, such as light exposure speed, peak value of the illuminating laser beam, and pulse width, are preferably used.

The thickness of the photoresist layer may preferably be determined in accordance with the kind of etching gas used in the etching process or the depth of the holes formed in the photoresist layer.

This thickness may be set appropriately, for example, in the range of 1-10,000 nm. The lower limit of the thickness is preferably 10 nm or more, and more preferably 30 nm or more. If the lower limit value of the thickness is set as described above, a desired effect as an etching mask can be achieved effectively. Meanwhile, the upper limit of the thickness is preferably 1,000 nm or less, and more preferably 500 nm or less. If the upper limit value is set as described above, a large laser power becomes unnecessary, a deep hole can be formed easily, and the processing speed can be increased.

Further, it is preferable that the thickness t of the photoresist layer and the diameter d of the hole has the following relationship. Namely, the upper limit value of the thickness t of the photoresist layer preferably takes a value to satisfy the relationship as given by t<10d, more preferably takes a value to satisfy t<5d, and still more preferably to satisfy t<3d. The lower limit value of the thickness t of the photoresist layer preferably takes a value to satisfy the relationship as given by t>d/100, more preferably takes a value to satisfy t>d/10, and still more preferably to satisfy t>d/5. If the upper limit and lower limit values of the thickness t of the photoresist layer have the aforementioned relationships, the advantages similar to those described above such as the desired effect as etching mask and increased processing speed can be achieved.

### EXAMPLES

Next, one example implemented to verify the advantageous effects of the present invention will now be described.

In the example, a plurality of rectangular workpieces each measuring 20 mm per side were put on a supporting stage measuring 120 mm in diameter, and the supporting stage was rotated at such a rate that the linear velocity of each workpiece exhibited 0.1 m/s; then, focus servo control and processing were carried out on the plurality of workpieces using a laser of 405-nm wavelength and an optical system of NA 0.85. Each workpiece was composed of a substrate and a photoresist layer. Details were as follows.
- Substrate
   - Material:: silicon
   - Thickness:: 0.5 mm
- Dye layer (Photoresist layer)
   2 g of a dye material given by the following chemical formula was dissolved in 100 ml of TFP (tetrafluoropropanol) solvent, and the resulting solution was spin coated. In this spin-coating process carried out with a dispense-start rotation speed of 500 rpm and a dispense-end rotation speed of 1,000 rpm, a coating liquid was dispensed onto the inner-radius area of the substrate, and the rotation speed was gradually increased to 2,200 rpm. The refractive index n of the dye material was 1.986 and the extinction coefficient k of the dye material was 0.0418.

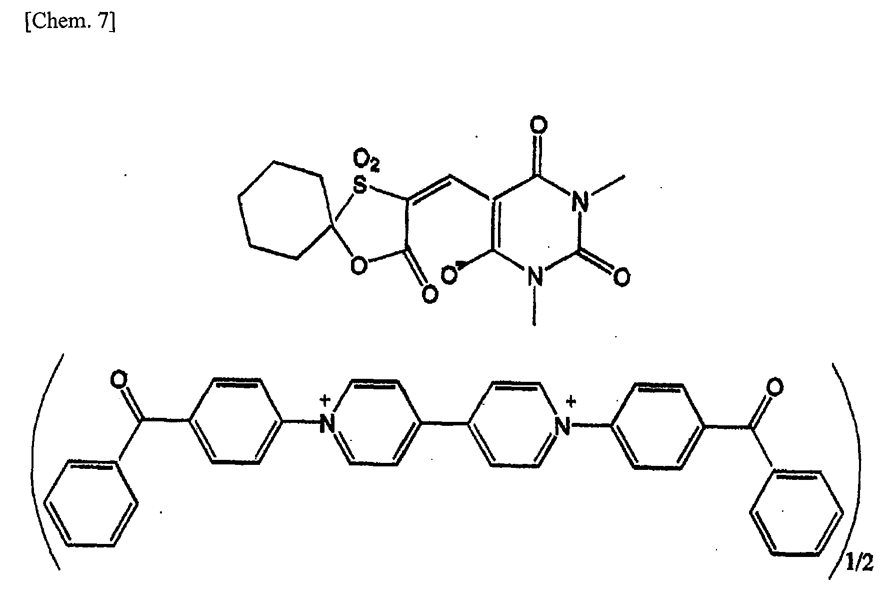

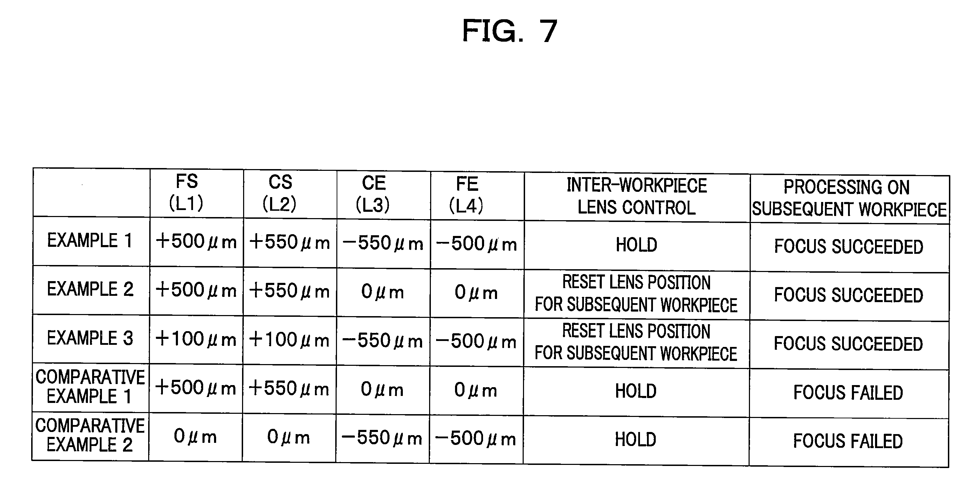

Focus start position FS, processing start position CS, processing stop position CE and focus stop position FE were set for EXAMPLEs 1-3 and COMPARATIVE EXAMPLEs 1-2, respectively, as shown in TABLE of FIG. 7. In this TABLE, the distance from the front end 5b of the workpiece 5 (*see* FIG. 4) is indicated by a positive value, and the distance from the rear end 5c of the workpiece 5 is indicated by a negative value.

### [EXAMPLE 1]

The focus start position FS (L1 in FIG. 4) was set at +500 µm, the processing start position CS (L2) was set at +550 µm, the processing stop position CE (L3) was set at -550 µm, the focus stop position FE (L4) was set at -500 µm. This means that, in EXAMPLE 1, each position was set so that a laser beam would never be applied outside, beyond the front end 5b and the rear end 5c, of the workpiece 5. Also, each position was set so that the control processes were executed in the order of: starting a focus servo control, starting a processing, stopping the processing and stopping the focus servo control. After the focus servo control was stopped, the objective lens 35 was held in place as it was when the control was stopped. As a result, it has been shown that the focus servo control for a subsequent workpiece 5 was exercised effectively.

### [EXAMPLE 2]

The focus start position FS (L1) was set at +500 µm, the processing start position CS (L2) was set at +550 µm, the processing stop position CE (L3) was set at 0 µm, the focus stop position FE (L4) was set at 0 µm. This means that, in EXAMPLE 2, the processing stop position CE and the focus stop position FE were set at positions such that the laser beam would possibly be applied outside, beyond the rear end 5c, of the workpiece 5. After the focus servo control was stopped, the position of the objective lens 35 was reset with reference to the surface position of the subsequent workpiece 5.

As a result, it has been shown that even if the laser beam was applied outside, beyond the rear end 5c, of the workpiece 5, and the objective lens 35 was moved to an undesirable position, the lens position resetting step caused the objective lens 35 to move to, and then be retained at, a position corresponding to the surface of the subsequent workpiece 5 with the result that the focus servo control for the subsequent workpiece 5 was exercised effectively.

### [EXAMPLE 3]

The focus start position FS (L1) was set at +100 µm, the processing start position CS (L2) was set at +100 µm, the processing stop position CE (L3) was set at -550 µm, the focus stop position FE (L4) was set at -500 µm. This means that, in EXAMPLE 3, the focus servo control and the processing were started at the same time. After the servo control was stopped, the position of the objective lens 35 was reset with reference to the surface position of the subsequent workpiece 5. As a result, it has been shown that even in cases where the focus servo control and the processing were started at the same time, the focus servo control for the subsequent workpiece 5 was exercised effectively. It has also been shown that even with the distances L1 and L2 of 100 µm, the focus servo control was exercised effectively.

### [COMPARATIVE EXAMPLE 1]

The focus start position FS (L1) was set at +500 µm, the processing start position CS (L2) was set at +550 µm, the processing stop position CE (L3) was set at 0 µm, the focus stop position FE (L4) was set at 0 µm. This means that, in COMPARATIVE EXAMPLE 1, the processing stop position CE and the focus stop position FE were set at positions such that the laser beam would possibly be applied outside, beyond the rear end 5c, of the workpiece 5. After the focus servo control was stopped, the objective lens 35 was held in place as it was when the control was stopped.

As a result, it has been shown that the focus servo control for the subsequent workpiece 5 could not successfully be exercised. This was probably because once the laser beam was applied outside, beyond the rear end 5c, of the workpiece 5 and the objective lens 35 was moved to an undesirable position, the objective lens 35 would be retained at this undesirable position with the result that the focus servo control could not effectively be exercised for the subsequent workpiece 5.

### [COMPARATIVE EXAMPLE 2]

The focus start position FS (L1) was set at 0 µm, the processing start position CS (L2) was set at 0 µm, the processing stop position CE (L3) was set at -550 µm, the focus stop position FE (L4) was set at -500 µm. This means that, in COMPARATIVE EXAMPLE 2, the focus start position FS and the processing start position CS were set at positions such that the laser beam would possibly be applied outside, beyond the front end 5b, of the workpiece 5. After the focus servo control was stopped, the objective lens 35 was held in place as it was when the control was stopped.

As a result, it has been shown that the focus servo control for the subsequent workpiece 5 could not be successfully be exercised. This was probably because even in cases where the objective lens 35 was retained at a desirable position after the focus servo control was stopped, the laser beam at the focus start position FS of the subsequent workpiece 35 was applied outside, beyond the front end 5b, of the subsequent workpiece 5 and thus the objective lens 35 was moved to an undesirable position with the result that the focus servo control could not effectively be exercised therefor.

### [EXAMPLE 4]

Instead of the dye material given by the chemical formula 7 as shown above, the following three kinds of dye material were used to make a workpiece, and the same experiments as described above in EXAMPLEs 1-3, were performed.
<Oxonol>

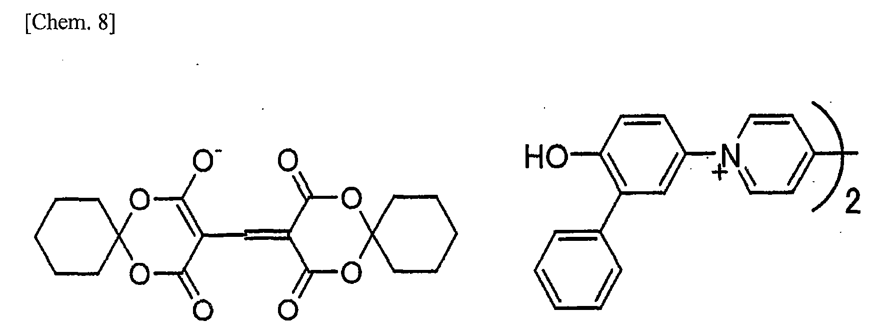

Refractive index n: 1.83; extinction coefficient k: 0.2
<Cyanine>

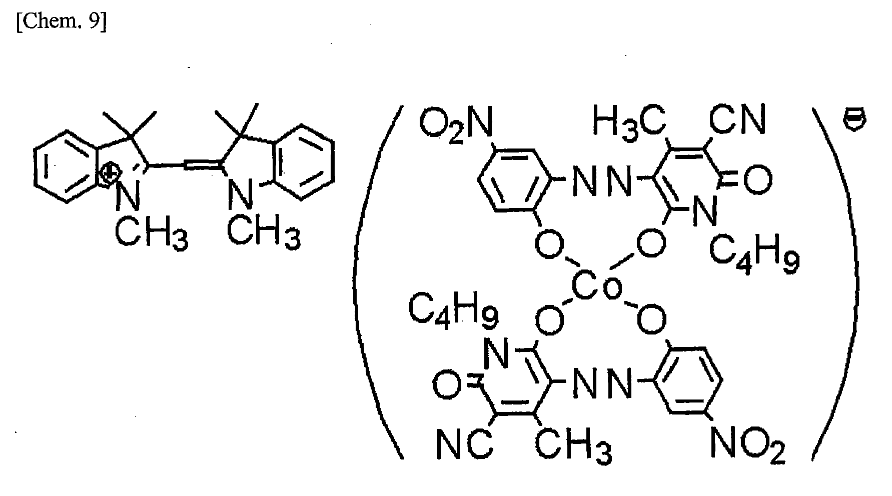

Refractive index n: 1.45; extinction coefficient k: 0.4
<Phthalocyanine>

ZnPc(α-SO₂Bu-sec)₄

Refractive index n: 1.82; extinction coefficient k: 0.14

The results were: it has been shown that with any of the dyes, the focus servo control was exercised successfully. That is, reflected light was obtained from the dye layer, and thus an effective focus servo control was realized.

## Claims

1. A laser exposure method for exposing a plurality of objects with a laser beam, in which a supporting stage supporting the plurality of objects spaced out thereon and a laser beam illumination device illuminating the objects with the laser beam while a focus servo control is being effected, under which an optical component thereof is moved based on reflected light, are moved relative to each other in a direction of arrangement of the plurality of objects, the laser exposure method comprising:
a control start step of starting the focus servo control, on condition that the laser beam emitted from the laser beam illumination device has reached a focus start position on an object;
a control stop step of stopping the focus servo control, on condition that the laser beam emitted from the laser beam illumination device has reached a focus stop position on the object; and
a retaining step of retaining a position of the optical component at a predetermined position for a period starting from a time when the laser beam emitted from the laser beam illumination device has reached the focus stop position on the object until the laser beam emitted from the laser beam illumination device reaches a focus start position on a subsequent object.

2. The laser exposure method according to claim 1, wherein the focus start position and the focus stop position are positions in which the laser beam in its entirety is applied to the object.

3. The laser exposure method according to claim 1, which comprises continuing to emit the laser beam uninterruptedly or intermittently from the laser beam illumination device during the retaining step.

4. The laser exposure method according to claim 3, which comprises continuing to emit the laser beam intermittently from the laser beam illumination device during the control start step, the control stop step and the retaining step.

5. The laser exposure method according to claim 1, wherein the predetermined position is a position of the optical component located when the focus servo control is stopped.

6. The laser exposure method according to claim 1, wherein the predetermined position is in a position corresponding to a surface of the subsequent object which is to be illuminated next.

7. The laser exposure method according to claim 1, wherein the predetermined position is in a position corresponding to an interval between peaks of an S-curve of a focus error signal.

8. The laser exposure method according to claim 1, which comprises rotating the supporting stage to cause the plurality of objects to revolve around an axis of rotation of the supporting stage.

9. The laser exposure method according to claim 8, wherein the laser beam is applied to a portion of the object which is defined to range between a position not less than 1 µm inside from an edge closer to the axis of rotation of the supporting stage and a position not less than 1 µm inside from an edge farthest from the axis of rotation of the supporting stage.

10. A photoresist layer processing method in which a supporting stage supporting a plurality of objects each having a photoresist layer, the plurality of objects being spaced out thereon, and a laser beam illumination device illuminating photoresist layers of the objects with a laser beam while a focus servo control is being effected, under which an optical component thereof is moved based on reflected light, are moved relative to each other in a direction of arrangement of the plurality of objects, to expose the photoresist layers of the plurality of objects with the laser beam, the photoresist layer processing method comprising:
a control start step of starting the focus servo control, on condition that the laser beam emitted from the laser beam illumination device has reached a focus start position on an object;
a control stop step of stopping the focus servo control, on condition that the laser beam emitted from the laser beam illumination device has reached a focus stop position on the object; and
a retaining step of retaining a position of the optical component at a predetermined position for a period starting from a time when the laser beam emitted from the laser beam illumination device has reached the focus stop position on the object until the laser beam emitted from the laser beam illumination device reaches a focus start position on a subsequent object.

11. The photoresist layer processing method according to claim 10, which comprises:
a processing start step of increasing a laser beam output to a level greater than that of the laser beam outputted at a time of starting the focus servo control, on condition that the laser beam has reached a processing start position on the object, the processing start position being set at a position rearward of the focus start position with respect to a moving direction of the objects; and
a processing stop step of lowering the laser beam output to a level of the laser beam outputted at the time of starting the focus servo control, on condition that the laser beam has reached a processing stop position on the object, the processing stop position being set at a position forward of the focus stop position with respect to the moving direction of the objects.

12. The photoresist layer processing method according to claim 11, wherein the processing start step comprises increasing the laser beam output to a level greater than that of the laser beam outputted at the time of starting the focus servo control, on condition, in lieu of said condition, that a distance at which the optical component is short of an in-focus position thereof, as determined during the focus servo control, has fallen within ±300 µm.

13. The photoresist layer processing method according to claim 10, comprising executing a processing prohibition control when a distance at which the optical component is short of an in-focus position thereof, as determined during the focus servo control, has fallen out of a predetermined range, wherein the processing prohibition control includes causing a laser beam output to be changed to or maintained at a level of the laser beam outputted at a time of starting the focus servo control.

14. The photoresist layer processing method according to claim 13, comprising moving at least one of the supporting stage and the laser beam illumination device relative to each other when the processing prohibition control is executed, to locate the laser beam back to the same position as a focus start position that is being set at a time of execution of the processing prohibition control.

15. The photoresist layer processing method according to claim 10, comprising recording defect information in a memory when a distance at which the optical component is short of an in-focus position thereof, as determined during the focus servo control, has fallen out of a predetermined range, wherein the defect information corresponds to the focus start position in the focus servo control.

16. The photoresist layer processing method according to claim 10, comprising stopping all controlling operations when a distance at which the optical component is short of an in-focus position thereof, as determined during the focus servo control, has fallen out of a predetermined range.

17. The photoresist layer processing method according to claim 10, wherein the photoresist layer is formed of a thermally deformable heat mode material.

18. A method for manufacturing a patterned casting, the method comprising utilizing a pattern of holes formed in the photoresist layer by the photoresist layer processing method according to any one of claims 10-17, to manufacture a patterned casting on which a shape corresponding to the pattern of holes is formed.
